# EUROPEAN PATENT SPECIFICATION

(11) **EP 1 959 525 B1**
(45) Date of publication and mention of the grant of the patent: **11.05.2016**
(21) Application number: 08101659.4
(22) Date of filing: 15.02.2008
(51) Int. Cl.: H01R 13/719, H01F 17/06, H01F 27/38, H01R 13/6461, H01R 24/64, H01F 17/00, H03H 1/00

(54) **Connector including isolation of magnetic devices capable of handling high speed communications**
Verbinder mit isolierenden Magnetvorrichtungen zur Bewältigung von Hochgeschwindigkeitsdatenübertragungen
Connecteur avec dispositifs magnétiques d'isolation capables de gérer des transmissions des données des grandes vitesses

(30) Priority: 16.02.2007 US 675701
(43) Date of publication of application: 20.08.2008
(73) Proprietor: Bel Fuse (Macao Commercial Offshore) Ltd. (MCO), 13 Andar H-K (MO)
(72) Inventor: Buckmeier, Brian J., San Diego, CA 92117 (US); Hess, John, Timonium, MD 21043 (US); Edralin, Edwin, San Diego, CA 92127 (US); Berry, Joseph, San Diego, CA 92128 (US)
(74) Representative: Ripamonti, Enrico

(56) References cited:
- WO-A-96/04737
- US-A- 3 548 492
- US-A- 5 077 543
- US-A- 5 200 718
- US-A- 5 705 961
- US-A- 5 726 611

## Description

### BACKGROUND OF THE INVENTION

Regulations for connector technology are evolving. As signal speeds increase and the connector industry desires to move data faster over a Cat 5 or equivalent cable, there is a need for isolating magnetic devices capable of handling higher magnetizing forces and DC current bias. In a typical RJ45 type connector assembly where a modular plug mates in a male-female relationship with a modular jack, an isolating magnetic device is used in the female connector portion to handle direct current ("DC") offsets. Such offsets may be caused by various factors including imbalances in the wires of the plug.

For example, data is frequently transmitted over a pair of conductive wires. When transmitting data, the pair of wires may ideally have voltage potentials to ground such that a voltage in one wire of the pair is equal and opposite to the voltage in the other wire of the pair. For example, one wire may have a potential of -2.5 volts and the other wire may have a potential of +2.5 volts. If there are imbalances in the pair of wires or extraneous electro-magnetic interference, the two wires may not have exactly equal and opposite voltages. For example, one wire may have -2 volts and the other wire may have +3 volts. Although there is still a net difference across the pair of wires of +5 volts (which may, for example, correspond to a logic "1"), such a voltage imbalance will generate a current imbalance. Conventional technology uses isolating magnetic devices and/or transformers to deal with such imbalances. However, prior art magnetic devices cannot physically handle the magnetizing force which may be induced by imbalanced DC current having high frequencies.

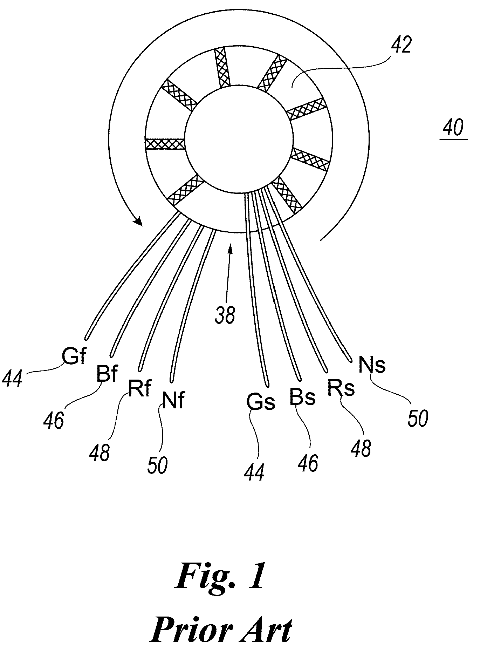

As an illustrative example, referring to Fig. 1, there is shown a transformer 40 in accordance with the prior art. Transformer 40 may be used as an isolating magnetic device. Transformer 40 is formed by winding wires 44, 46, 48 and 50 around a toroid shaped core 42. Core 42 has a substantially circular cross-section. Wires 44, 46, 48 and 50 are evenly wound around core 42 except in a gap area 38.

Such prior art solutions as discussed above can handle perhaps as much as 2 million bits per second. However, newer standards require that communications occur as high as one (1) or even ten (10) gigabits per second. The above prior art isolation magnetic device generally does not have the frequency response characteristic needed to inhibit the presence of DC current bias with communications of such speeds. Even those solutions capable of handling high speed (e.g. 2M bits per second) communications are not backward compatible (i.e. they cannot handle slower communications) and are frequently not in a conventional RJ45 type connector format. Such a format is common in the industry and most users have become comfortable with it.

Therefore, there is a need in the art for an isolation magnetic device which can handle high speed communications, is backward compatible, and which can conform to standard RJ45 type connector arrangements. There is also a need for a method for manufacturing such a device.

WO9604737 describes a termination which is provided for a differential transmission line such as unshielded twisted pair (UTP) to isolate a connected device from electromagnetic interference present on the UTP in the form of differential mode and common mode noise. An example of an electromagnetic interference isolator comprises a common mode and a differential mode termination, a common mode choke which exhibits substantially constant impedance over a wide bandwidth and a centre tapped isolation transformer.

US5726611 relates to an EMC filter for a balanced multi-wired telecommunication line which has an oblong closed magnetic path core having at least one first core arm with a first length and second core arms with a second length which is equal to or shorter than the first length, and a plurality of coils constituted by at least one pair of wires. The at least one first core arm and the second core arm constitute a closed magnetic path. The wires of each pair are closely positioned each other and wound around the at least one first core arm so as to produce magnetic fluxes in the first core arm flowing toward the same direction when a common-mode current flows through the wires. Each of the coils has a signal input end and a signal output end, and the wires run in a one-way direction from the signal input ends to the signal output ends, respectively.

US5705961 describes an induction device for high radio frequency signal distributor which is able to act as a right signal distributing induction device on the right side of the high radio frequency signal distributor and act as a left signal distributing induction device on the left side of the high radio frequency signal distributor. Accordingly, the induction device comprises a pair of conductive cores and a plurality of enamel copper wires or insulated copper wires intertwined around the two cores in predetermined manner for accommodating high radio frequency signal distributor so as to enable the transmission frequency range of radio frequency signal distributing circuit to extend to 1000 MHz.

US5200718 teaches a balun transformer with a common mode coil and formed by parallel two-strand cable wound around a common core having through-holes through which the cable passes. The common mode coil can be connected either on the input side or the output side of the balun transformer.

US5077543 relates to a balanced T-section low-pass common mode filter which is connected in series with balanced data I/O lines to remove common mode signals from balanced line difference mode signals. The filter includes input and output series transformers configured so that the magnetic fields in the transformers are subtractive for out-of-phase difference mode signals and additive for in-phase common mode signals and shunt transformer coupled to ground configured so that the magnetic fields in the transformer are additive for out-of-phase difference mode signals and subtractive for in-phase common mode signals.

US3548492 describes a method of adjusting inductive devices. According to this document, the inductance or coupling value of an inductor or a transformer is adjusted to a desired value by removing a portion of the core by means of abrasive-filled gas to form an air gap. Instead of a unitary core, the transformer may comprise two inductors placed side-by side. Preferably a servo-system connected between a measuring instrument and the air-abrasive unit terminates the air-flow when the desired value is reached.

### SUMMARY OF THE INVENTION

One aspect of the invention is a connector for enabling electrical communication with a plug according to claim 1.

### BRIEF DESCRIPTION OF THE DRAWINGS

A more complete appreciation of the present invention and many of the attendant advantages thereof will be readily understood by reference to the following detailed description when taken in conjunction with the accompanying drawings in which:
Fig. 1 is a front view of a transformer in accordance with the prior art;
Fig. 2 is a side view of a core for use in accordance with an embodiment of the invention;
Fig. 3 is a side cutaway view of an isolating magnetic device for use in accordance with an embodiment of the invention;
Fig. 4 is a side view of an isolating magnetic device and a common mode choke used in accordance with an embodiment which is not part of the invention; and
Fig. 5 is a diagram of a circuit including some tolerances of circuit devices including an isolating magnetic device and a common mode choke used in accordance with an embodiment of the invention.

### DETAILED DESCRIPTION OF THE PREFERRED EMBODIMENT(S)

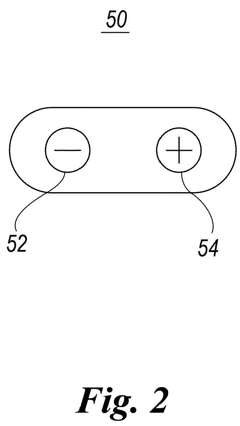

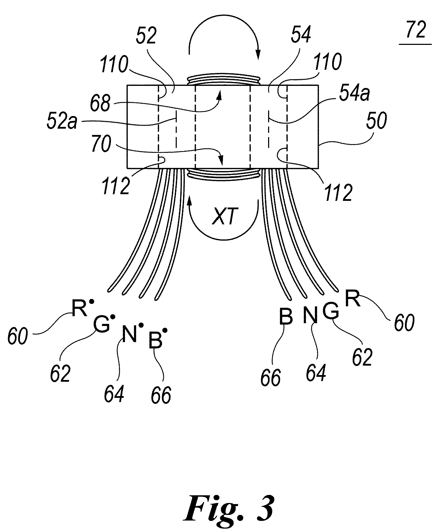

Referring now to the drawings wherein like reference numerals describe identical or corresponding parts throughout the several view, and more particularly to Figs. 2 and 3, a core 50 is shaped substantially like an ellipsoid with its ends cut off and has a substantially racetrack-shaped cross-section. Core 50 includes a first hole 52 and a second hole 54 that extend longitudinally through the core with parallel longitudinal axes 52a, 54a respectively. The first and second holes 52, 54 each have opposed first and second and 110, 112 opening onto respective first and second opposite sides 68, 70 of core 50. Core 50 may have, for example, a material permeability of 5,000.

Referring to Fig. 3, core 50 is used to produce an isolation magnetic device in accordance with an embodiment which is not part of the invention. As shown in Fig. 3, four pairs of wires 60, 62, 64 and 66 (shown as having colors red, green, natural and blue respectively) are wound around core 50. Each pair of wires 60, 62, 64, 66 may be initially twisted together. For example, the two red wires 60 are twisted together, the two green wires 62 are twisted together, etc. For example, Y number of twists may be made per each inch of wire. The wires may be, for example, MW83C class 180 (40QPN-180), AWG#40 wires. After the pairs of wires 60, 62, 64 and 66 are twisted, all four pairs are then inserted through hole 52, wrapped around a portion of the side 68 of core 50 between the ends 1₁0 of holes 52, 54 and inserted through hole 54. If desired, wires 60, 62, 64 and 66 may then be wrapped around a portion of the second side 70 of core 50 between the ends 112 of holes 52, 54 and then inserted through hole 52 wrapped around side 68 and then inserted through hole 54 a desired number of windings. For example X number of windings may be used. In this way, an isolating magnetic device 72 may be formed. Such an isolating magnetic device can handle communications of 10 gigabits per second and still be backward compatible so as to handle 10/100/1000 Base T communications. Such communication speeds are now required under IEEE standard 802.3. As shown in Fig. 3, dot notation is used to assist an assemblyman in assembling the device. The dots may indicate a starting point of each of wires 60, 62, 64 and 66.

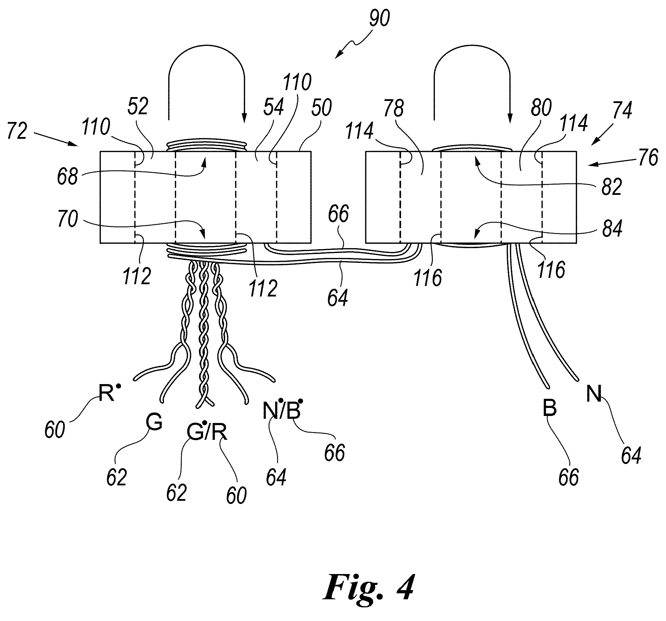

Referring now to Fig. 4, magnetic device 72 can be combined with a common mode choke 74. After isolating magnetic device 72 is formed as was described with reference to Fig. 3, ends of wires 60, 62, 64 and 66 are twisted together. For example, a beginning of wire 60 (red) and ending of wire 62 (green) are twisted together. Similarly, **a beginning** of wire 62 (green) **and end** of wire 60 (red) are twisted together. A beginning of wire 64 (natural) and **a beginning** of wire 66 (blue) are twisted together. Note that the ending of wire 64 and **the ending** of wire 66 are not twisted together for isolating magnetic device 72. As choke 74 is used, the ending of wire 64 and the **ending** of wire 66 are extended **in untwisted form** to a second core 76 which may be used to form a common mode choke 74. Core 76 may have the same construction as core 50 shown in Fig. 2 with, for example, a material permeability of 2500. That is, core 76 may have a first **longitudinally extending** hole 78, a second **longitudinally extending** hole 80 and first and second sides 82 and 84 respectively. **Each of the holes 78, 80 have opposed first and second ends 114, 116 opening onto respective opposite sides 82, 84 of core 76.** In forming common mode choke 74, wires 64 and 66 are inserted through hole 78 wrapped around **the portion of the** first side 82 of core **76 between the ends 114 of holes 78, 80** and then inserted through hole 80. If desired, wires 66 and 64 may then be wrapped around **the portion of the** second side 84 **of core 76 between the ends 116 of holes 78, 80,** inserted through hole 78, wrapped around first side 82 and inserted through a hole 80 a desired number of windings. For example, three windings may be used. After a desired number of windings have been made around core 76, wires 64 and 66 are individually twisted.

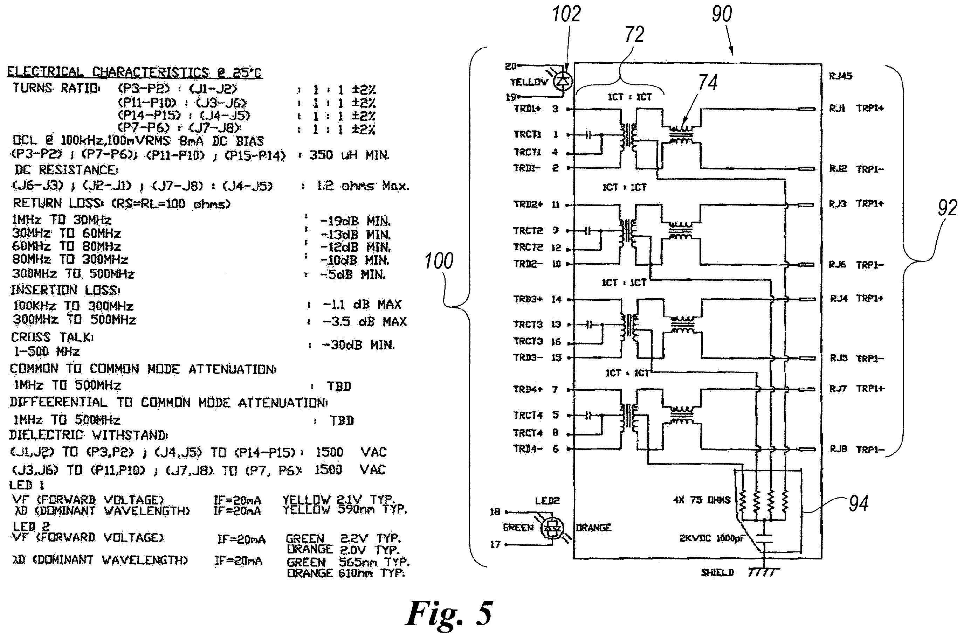

Referring now to Fig. 5 there is shown a circuit 90 which could use electric device 72 and common mode choke 76 described above. Also shown are some tolerances which could be used for the circuit devices in circuit 90. Circuit 90 is used in a connector and facilitate data communications between the connector and a plug (not shown). Circuit 90 includes contacts 92 which may communicate with the terminals of an inserted plug. An optional termination circuit 94 may be used to balance a load of wires in said plug. A magnetic filter circuit comprising one or both of common mode choke 74 and isolating magnetic device 72 may be coupled to or placed in communication with contacts 92. Terminals 100 may be used to transfer data to a device connected to circuit 90 or to the connector using circuit 90, and are coupled to or placed in communication with the magnetic filter circuit. Optional light emitting diodes 102 may be also used.

Circuit 90, incorporating device 72, may be used for communications of 10 Giga bits per second and may also be backward compatible so as to handle communications at speeds of 10 Base T, 100 Base T and 1,000 Base T. Moreover, circuit 90 may be used in a standard RJ45 type connector configuration. A winding method in accordance with the invention may use standard wiring making manufacture simple and easily available.

While preferred embodiments of the invention have been shown, the invention is only limited as defined by the scope of the accompanying claims.

## Claims

1. A connector (102) for enabling electrical communication with a plug, the connector including connector contacts (92) effective to engage terminals of the plug and connector terminals (100), the connector further including a magnetic filter (90) in communication with the contacts (92) and terminals (100), **characterized in that**
the magnetic filter (90) includes an isolating magnetic device (72), the isolation magnetic device including a first core (50) having a racetrack-shaped cross-section, the first core (50) having a first longitudinally extending hole (52) with a first longitudinal axis and a second longitudinally extending hole (54) spaced from the first hole (52), the second hole (54) having a second longitudinal axis parallel to the first longitudinal axis, the first and second holes (52, 54) each having opposed first and second ends (110, 112) opening onto respective first and second opposite sides (68, 70) of the first core (50);
the isolating magnetic device (72) further including first, second, third and fourth wire pairs (60, 62, 64, 66) inserted through the first hole (52) of the first core (50), wrapped around a first portion of the first side (68) of first core (50) between the first ends (110) of the first and second holes (52, 54), inserted through the second hole (54) of the first core (50), wrapped around a second portion of the second side (70) of the first core (50) between the second ends (112) of the first and second holes (52, 54), and then reinserted through the first hole (52), wrapped around the first portion of the first side (68) of the first core (50), reinserted through the second hole (54) and wrapped around the second portion of the second side (70) of the first core (50) a desired number of times, each wire pair (60, 62, 64, 66) having a first end (R-, G-, N , B) which is not inserted through the core holes (52, 54) and a second end (R, G, N, B) exiting from the second end (112) of the second hole (54) of the first core (50), and wherein the first end (R-) of the first wire pair (60) is twisted together with the second end (G) of the second wire pair (62), the first end (G-) of the second wire pair (62) is twisted together with the second end (R) of the first wire pair (60); and the first end (N- ) of the third wire pair (64) is twisted together with the first end (B- )of the fourth wire pair (66); and wherein
the magnetic filter (90) further including a common mode choke (74), the common mode choke (74) including a second core (76) shaped substantially cylindrically having a racetrack-shaped cross-section, the second core (76) having a third longitudinally extending hole (78) with a third longitudinal axis and a fourth longitudinally extending hole (80) spaced from the third hole (78) having a fourth longitudinal axis parallel to the third longitudinal axis, the third and fourth holes (78, 80) each having opposed first and second ends (114, 116) opening onto respective first and second opposite sides (82, 84) of the second core (76);
the common mode choke (74) further including the third and fourth wire pairs (64, 66), the second end (N) of the third wire pair (64) and the second end (B) of the fourth wire pair (66) extending from the isolating device (72) in untwisted form being inserted through the third hole (78) of the second core (76), wrapped around a first portion of the first side (82) of the second core (76) between the first ends (114) of the third and fourth holes (78, 80), inserted through the fourth hole (80) of the second core (76), wrapped around a second portion of the second side (84) of the second core (76) between the second ends (116) of the third and fourth holes (78, 80), and then reinserted through the third hole (78), wrapped around the first portion of the first side (82) of the second core (76), reinserted through the fourth hole (80) of the second core (76) and wrapped around the second portion of the second side (84) of the second core (76) a desired number of times.

## Patentansprüche

1. Verbinder (102) zum elektrischen Anschluss mit einem Stecker, wobei der Verbinder Kontakte (92) umfasst, um die Anschlussklemmen der Steck- und Klemmanschlüsse (100) zu kuppeln, wobei der Verbinder weiter einen magnetischen Filter (90) umfasst, der mit den Kontakten (92) und Anschlüssen (100) in Verbindung ist, **dadurch gekennzeichnet, dass** der magnetische Filter (90) eine isolierende Magnetvorrichtung (72) umfasst, wobei die isolierende Magnetvorrichtung eine erste Ader (50) umfasst, die einen rennbahnförmigen Querschnitt hat, wobei die erste Ader (50) ein erstes längs verlaufendes Loch (52) mit einer ersten Längsachse und ein zweites längs verlaufendes, von dem ersten Loch (52) beabstandetes Loch (54) hat, wobei das zweite Loch (54) eine zweite, zu der ersten Längsachse parallel verlaufende Längsachse hat, wobei jedes des ersten und des zweiten Lochs (52, 54) entgegengesetzte erste und zweite Enden (110, 112) hat, die an entsprechenden ersten und zweiten entgegengesetzten Seiten (68, 70) der ersten Ader (50) herausgehen;
wobei die isolierende Magnetvorrichtung (72) weiter ein erstes, ein zweites, ein drittes sowie ein viertes Leiterpaar (60, 62, 64, 66) hat, die durch das erste Loch (52) der ersten Ader (50) hineingesteckt, um eine erste Portion der ersten Seite (68) der ersten Ader (50) zwischen den ersten Enden (110) des ersten und des zweiten Lochs (52, 54) gewickelt, durch das zweite Loch (54) der ersten Ader (50) hineingesteckt, um eine zweite Portion der zweiten Seite (70) der ersten Ader (50) zwischen den zweiten Enden (112) des ersten und des zweiten Lochs (52, 54) gewickelt und danach durch das erste Loch (52) wieder hineingesteckt, um die erste Portion der ersten Seite (68) der ersten Ader (50) gewickelt, durch das zweite Loch (54) wieder hineingesteckt und um die zweite Portion der zweiten Seite (70) der ersten Ader (50) so häufig wie gewünscht gewickelt werden, wobei jedes Leiterpaar (60,62,64,66) ein erstes Ende (R-, G-, N-, B-) hat, das durch die Löcher (52, 54) der Ader nicht hineingesteckt ist, und ein zweites End (R, G, N, B) hat, das aus dem zweiten Ende (112) des zweiten Lochs (54) der ersten Ader (50) herauskommt, und worin das erste Ende (R-) des ersten Leiterpaars (60) mit dem zweiten Ende (G) des zweiten Leiterpaars (62) zusammengedreht ist und das erste Ende (G-) des zweiten Leiterpaars (62) mit dem zweiten Ende (R) des ersten Leiterpaars (60) zusammengedreht ist; und worin das erste Ende (N-) des dritten Leiterpaars (64) mit dem ersten Ende (B-) des vierten Leiterpaars (66) zusammengedreht ist; und worin
der magnetische Filter (90) weiter eine Gleichtaktdrossel (74) umfasst, wobei die Gleichtaktdrossel (74) eine grundsätzlich walzenförmige zweite Ader (76) umfasst, die einen rennbahnförmigen Querschnitt hat, wobei die zweite Ader (76) ein drittes längs verlaufendes Loch (78) mit einer dritten Längsachse und ein viertes längs verlaufendes, von dem dritten Loch (78) beabstandetes Loch (80) hat, wobei das vierte Loch eine vierte, zu der dritten Längsachse parallel verlaufende Längsachse hat, wobei jedes des dritten und des vierten Lochs (78,80) entgegengesetzte erste und zweite Enden (114, 116) hat, die an entsprechenden ersten und zweiten entgegengesetzten Seiten (82, 84) der zweiten Ader (76) herausgehen;
wobei die Gleichtaktdrossel (74) weiter das dritte und vierte Leiterpaar (64, 66) umfasst, wobei das zweite Ende (N) des dritten Leiterpaars (64) und das zweite Ende (B) des vierten Leiterpaars (66), die aus der isolierende Vorrichtung (72) in ungedrehter Form herausgehen, durch das dritte Loch (78) der zweiten Ader (76) hineingesteckt, um eine erste Portion der ersten Seite (82) der zweiten Ader (76) zwischen den ersten Enden (114) des dritten und des vierten Lochs (78,80) gewickelt, durch das vierte Loch (80) der zweiten Ader (76) hineingesteckt, um eine zweite Portion der zweiten Seite (84) der zweiten Ader (76) zwischen den zweiten Enden (116) des dritten und des vierten Lochs (78, 80) gewickelt und danach durch das dritte Loch (78) wieder hineingesteckt, um die erste Portion der ersten Seite (82) der zweiten Ader (76) gewickelt, durch das vierte Loch (80) der zweiten Ader (76) wieder hineingesteckt und um die zweite Portion der zweiten Seite (84) der zweiten Ader (76) so häufig wie gewünscht gewickelt werden.

## Revendications

1. Connecteur (102) pour permettre la communication électrique avec une fiche, le connecteur comprenant des contacts de connecteur (92) qui agissent efficacement pour engager les pièces terminales des bornes fiche/connecteur (100), le connecteur comprenant aussi un filtre magnétique (90) en communication avec les contacts (92) et les bornes (100), **caractérisé en ce que**
le filtre magnétique (90) comprend un dispositif magnétique d'isolation (72), le dispositif magnétique d'isolation comprenant une première âme (50) ayant une section transversale en forme de piste, la première âme (50) ayant un premier trou (52) s'étendant longitudinalement avec un premier axe longitudinal et un deuxième trou s'étendant longitudinalement (54) espacé du premier trou (52), le deuxième trou (54) ayant un deuxième axe longitudinal parallèle au premier axe longitudinal, le premier et le deuxième trou (52, 54) ayant chacun des premières et des secondes extrémités opposées (110, 112) qui s'ouvrent sur des respectifs premiers et seconds côtés opposés (68, 70) de la première âme (50);
le dispositif magnétique d'isolation (72) comprenant aussi une première, une deuxième, une troisième et une quatrième paire de fils (60, 62, 64, 66) insérées à travers le premier trou (52) de la première âme (50), enroulées autour d'une première portion du premier côté (68) de la première âme (50) entre les premières extrémités (110) du premier et du deuxième trou (52, 54), insérées à travers le deuxième trou (54) de la première âme (50), enroulées autour d'une seconde portion du second côté (70) de la première âme (50) entre les secondes extrémités (112) du premier et du deuxième trou (52, 54) et ensuite réinsérées à travers le premier trou (52), enroulées autour de la première portion du premier côté (68) de la première âme (50), réinsérées à travers le deuxième trou (54) et enroulées autour de la seconde portion du second côté (70) de la première âme (50) un nombre désiré de fois, chaque paire de fils (60,62,64,66) ayant une première extrémité (R-, G-, N-, B-) qui n'est pas insérée à travers les trous de l'âme (52, 54) et une seconde extrémité (R, G, N, B) sortant de la seconde extrémité (112) du deuxième trou (54) de la première âme (50), et où la première extrémité (R-) de la première paire de fils (60) est torsadée avec la seconde extrémité (G) de la deuxième paire de fils (62), la première extrémité (G-) de la deuxième paire de fils (62) est torsadée avec la seconde extrémité (R) de la première paire de fils (60); et la première extrémité (N-) de la troisième paire de fils (64) est torsadée avec la première extrémité (B- )de la quatrième paire de fils (66); et où le filtre magnétique (90) comprend aussi une bobine d'arrêt de mode commun (74), la bobine d'arrêt de mode commun (74) comprenant une seconde âme (76) de forme substantiellement cylindrique avec une section transversale en forme de piste, la seconde âme (76) ayant un troisième trou s'étendant longitudinalement (78) avec un troisième axe longitudinal et un quatrième trou (80) s'étendant longitudinalement (80) espacé du troisième trou (78) et ayant un quatrième axe longitudinal parallèle au troisième axe longitudinal, le troisième et le quatrième trou (78,80) ayant chacun des premières et des secondes extrémités opposées (114, 116) qui s'ouvrent sur des respectifs premiers et seconds côtés opposés (82, 84) de la seconde âme (76);
la bobine d'arrêt de mode commun (74) comprenant aussi la troisième et la quatrième paire de fils (64, 66), la seconde extrémité (N) de la troisième paire de fils (64) et la seconde extrémité (B) de la quatrième paire de fils (66) s'étendant du dispositif d'isolation (72) en forme non torsadée étant insérées à travers le troisième trou (78) de la seconde âme (76), enroulées autour d'une première portion du premier côté (82) de la seconde âme (76) entre les premières extrémités (114) du troisième et du quatrième trou (78,80), insérées à travers le quatrième trou (80) de la seconde âme (76), enroulées autour d'une seconde portion du second côté (84) de la seconde âme (76) entre les secondes extrémités (116) du troisième et du quatrième trou (78, 80) et ensuite réinsérées à travers le troisième trou (78), enroulées autour de la première portion du premier côté (82) de la seconde âme (76), réinsérées à travers le quatrième trou (80) de la seconde âme (76) et enroulées autour de la seconde portion du second côté (84) de la seconde âme (76) pour un nombre désiré de fois.
